# EUROPÄISCHE PATENTSCHRIFT

(11) **EP 3 836 764 B1**
(45) Veröffentlichungstag und Bekanntmachung des Hinweises auf die Patenterteilung: **08.02.2023**
(21) Anmeldenummer: 19215746.9
(22) Anmeldetag: 12.12.2019
(51) Int. Cl.: H05K 7/14

(54) **ADAPTERELEMENT UND BAUTEIL ZUR VERBINDUNG MITEINANDER**
ADAPTER ELEMENT AND COMPONENT FOR CONNECTION WITH EACH OTHER
ÉLÉMENT ADAPTATEUR ET COMPOSANT SE RACCORDANT L'UN À L'AUTRE

(43) Veröffentlichungstag der Anmeldung: 16.06.2021
(73) Patentinhaber: Airbus Defence and Space GmbH, 82024 Taufkirchen (DE)
(72) Erfinder: Retat, Dr. Ingo, 28199 Bremen (DE); Arens, Lena, 28199 Bremen (DE)
(74) Vertreter: Marschall, Stefan

(56) Entgegenhaltungen:
- EP-A1- 0 288 859
- US-A- 5 458 432

## Beschreibung

Die vorliegende Erfindung betrifft ein Verbindungssystem mit einem Adapterelement und einem Bauteil, einen Raumflugkörper sowie je ein Verfahren zum Montieren und zum Lösen eines Bauteils an bzw. von einem Adapterelement.

Auf dem Gebiet der Raumfahrt, insbesondere bei Langzeit-Raumfahrt-Missionen gibt es immer wieder den Bedarf zur Wartung oder Erneuerung von Bauteilen, beispielsweise wenn ein Computer oder eine andere elektrische Einheit ausgetauscht werden soll. Während das Lösen bzw. Herstellen mechanischer oder elektrischer Verbindungen innerhalb von bemannten Raumschiffen im Allgemeinen jeweils einfach von Astronauten durchgeführt werden kann, ist der Aufwand außerhalb dieser Raumschiffe wesentlich höher, insbesondere weil Astronauten im Vakuum einen Druckanzug benötigen und die notwendigen druckdichten Handschuhe die Fingerfertigkeit so stark einschränken, dass nur spezielle mechanische und/oder elektrische Verbindungen zu bedienen sind. Die elektrische Verbindung von beispielsweise mehreren hundert elektrischer Leitungen kann dann praktisch unmöglich werden. Zudem erfordert das gleichzeitige Stecken und Lösen von sehr vielen Kontakten einen hohen Kraftaufwand, der kontrolliert aufgebracht werden muss, damit die z.T. empfindlichen Kontakte nicht beschädigt werden. Aber für zentrale elektronische Einheiten, die mit vielen anderen Systemen verbunden sind, sind gerade viele Leitungen notwendig und wünschenswert.

Oftmals soll ein Außeneinsatz von Astronauten auch ganz vermieden werden, weil z.B. der Aufwand zu groß ist und die damit verbundenen Kosten zu hoch sind oder weil die Astronauten mit anderen Aufgaben beschäftigt sind. Dann kommen im Weltraum Roboterarme zur Anwendung, deren fein-motorische Fähigkeiten noch eingeschränkter sind als die menschlichen unter den genannten Bedingungen.

Die Druckschrift EP 0 288 859 A1 offenbart eine Verriegelungsvorrichtung eines Gehäuses mit elektronischen Geräten auf einem Gestell. Aus der Druckschrift US 5 458 432 A ist ein Mechanismus zum Halten einer Einheit an einer Ablage bekannt.

Der vorliegenden Erfindung liegt die Aufgabe zugrunde, eine Technik bereitzustellen, mit der eine Montage und/oder Demontage von Bauteilen insbesondere unter Extrembedingungen wie beispielsweise im Außenbereich eines im Weltraum befindlichen Raumflugkörpers vereinfacht werden kann.

Die Aufgabe wird gelöst durch ein Steckverbindungssystem gemäß Anspruch 1, einen Raumflugkörper nach Anspruch 8 und durch Verfahren nach den Ansprüchen 9 und 10. Vorteilhafte Ausführungsformen sind in den Unteransprüchen, der Beschreibung und den Figuren offenbart.

Ein erfindungsgemäßes Verbindungssystem umfasst ein Adapterelement und mindestens ein dazu passendes, also mit dem Adapterelement verbundenes oder zu verbindendes Bauteil, jeweils gemäß einer der in dieser Schrift offenbarten Ausführungsformen. Es ermöglicht einen vereinfachten und kontrollierten Anschluss des Bauteils an das Adapterelement auch unter Extrembedingungen (beispielsweise im Weltraum oder unter Wasser) durch einen Roboter und/oder durch einen infolge der Bedingungen motorisch eingeschränkten Menschen. Insbesondere kann das Adapterelement an einem Außenbereich eines Raumflugkörpers angeordnet oder anzuordnen sein.

Das Adapterelement dient einem Anschließen des Bauteils, stellt also eine Anschlusskomponente für das Bauteil dar. Das Adapterelement umfasst ein oder mehrere elektrische/s Steckerelement(e), das/die zum Herstellen einer elektrischen Steckverbindung jeweils mit mindestens einer (jeweiligen) elektrischen Steckerkomponente des Bauteils zu verbinden ist/sind. Zum Herstellen der Steckverbindung sind das mindestens eine Steckerelement und die jeweilige Steckerkomponente relativ zueinander zu bewegen; die Richtung, in der sich dabei die Steckerkomponente relativ zum Steckerelement bewegt, wird im Folgenden als "vorgesehene Anschlussrichtung" bezeichnet.

Das mindestens eine Steckerelement kann insbesondere mindestens 10, mindestens 100, mindestens 250 oder sogar mindestens 600 Kontakte zur Verbindung jeweiliger elektrischer Leitungen umfassen. Es kann jeweils als weiblicher oder männlicher Teil einer Steckverbindung oder als Mischform ausgebildet sein.

Das Adapterelement des erfindungsgemäßen Verbindungssystems weist weiterhin mindestens zwei Aufnahmeelemente auf, die jeweils eine Aufnahme für ein am Bauteil angeordnetes Eingriffselement ausbilden. Die Aufnahmen erstrecken sich dabei jeweils von einer Eintrittsöffnung für das Eingriffselement zu einer für dieses vorgesehenen Montage-Endposition. In eine Richtung, die der vorgesehenen Anschlussrichtung entgegengesetzt ist, werden die Aufnahmen jeweils durch eine zugehörige Leitfläche begrenzt. Insbesondere kann beim Herstellen der Steckverbindung ein jeweiliges Eingriffselement am Bauteil vorzugsweise an einer derartigen Leitfläche entlanggeführt werden, beispielsweise gleitend oder mittels Rollen.

Die Leitflächen weisen dabei jeweils mindestens einen Abschnitt auf, der gekrümmt oder schräg zur vorgesehenen Anschlussrichtung verläuft. Vorzugsweise hat dabei der mindestens eine Abschnitt eine (vom Nullvektor verschiedene) Richtungskomponente in Anschlussrichtung: Wenn dann ein Eingriffselement an einem geeigneten Bauteil (insbesondere einem erfindungsgemäßen wie unten beschrieben) an einem derartigen Abschnitt der Leitfläche entlanggeführt wird, wird dadurch mindestens eine elektrische Steckerkomponente des Bauteils an das mindestens eine zum Adapterelement gehörige elektrischen Steckerelement angenähert bzw. wird die Steckverbindung von Steckerelement(en) und zugehöriger/n Steckerkomponente(n) vorzugsweise hergestellt.

So ermöglicht das Adapterelement mittels der Führung des Eingriffselements des Bauteils in der Aufnahme ein präzises Positionieren des Bauteils auch bei eingeschränkter Feinmotorik eines verbindenden Menschen oder eines Roboters. Das Risiko von Beschädigungen an den Steckkontakten wird dadurch minimiert. Insbesondere in Anwendungsbereichen, bei denen weder das Adapterelement noch das Bauteil stabil im Raum gelagert sind (beispielsweise also bei einer Anwendung im Weltraum oder unter Wasser schwimmend), können die Leitflächen das jeweilige Eingriffselement in der Aufnahme halten und so verhindern, dass eine auf das Bauteil ausgeübte Einsteckkraft anstelle eines beabsichtigten Herstellens der Steckverbindung(en) bewirkt, dass das Bauteil das Adapterelement vor sich her schiebt.

In Richtung von der Eintrittsöffnung zur Montage-Endposition des jeweiligen Eingriffselements hin betrachtet kann die Leitfläche in ihrem schrägen oder gekrümmten Abschnitt beispielsweise mit einem die vorgesehene Anschlussrichtung repräsentierenden Vektor (bei gekrümmtem Abschnitt im Mittel) einen (kleineren) Winkel α einschließen, der vorzugsweise wenigstens 25°, wenigstens 35° oder wenigstens 45° beträgt und/oder höchstens 85°, höchstens 75° oder sogar höchstens 65° beträgt. Insbesondere verläuft also der genannte Abschnitt weder parallel noch senkrecht zur vorgesehenen Anschlussrichtung.

Gemäß vorteilhaften Ausführungsformen bildet die Leitfläche, die die Aufnahme entgegen der vorgesehenen Anschlussrichtung begrenzt, zwischen der Montage-Endposition und der Eintrittsöffnung eine Kante aus. Alternativ oder zusätzlich kann die Aufnahme im Bereich der Montage-Endposition einen Abschnitt aufweisen, in dem die Leitfläche senkrecht zur vorgesehenen Anschlussrichtung verläuft oder in dem sich die Aufnahme sogar der vorgesehenen Anschlussrichtung entgegen erstreckt, so dass sie im Bereich der Montage-Endposition also eine Sicherungsnische für ein in seiner Montage-Endposition angeordnetes Eingriffselement umfasst. In einem mit dem Adapterelement verbundenen Zustand eines passenden Bauteils ist dadurch dann dessen Eingriffselement in seiner Montage-Endposition gesichert, so dass das Risiko eines selbsttätigen Herauslösens beispielsweise infolge von Vibrationen (wie sie beispielsweise durch eine Motortätigkeit an einem Raumflugkörper, insbesondere beim Start einer Rakete auftreten können) gemindert ist, ohne dass dafür ein zusätzlicher Kraftaufwand erforderlich ist.

Ein Aufnahmeelement eines erfindungsgemäßen Adapterelements kann im Bereich der Montage-Endposition seiner Aufnahme ein elastisches Element umfassen, das dazu eingerichtet ist, (im angeschlossenen Zustand des Bauteils) einen Schwingungsübergang zwischen Eingriffselement und Aufnahmeelement zu reduzieren bzw. abzudämpfen. In Ausführungsformen mit Sicherungsnische wie oben erwähnt kann ein derartiges elastisches Element insbesondere an einer Begrenzung der Sicherungsnische entgegen der vorgesehenen Anschlussrichtung angeordnet sein.

Die Aufnahme mindestens eines der Aufnahmeelemente des Adapterelements eines erfindungsgemäßen Verbindungssystems ist auch der vorgesehenen Anschlussrichtung folgend in mindestens einem Teilbereich durch eine Fläche begrenzt, die gekrümmt oder schräg zur vorgesehenen Anschlussrichtung verläuft. Diese Fläche wird im Folgenden als "Lauffläche" bezeichnet. Sie ermöglicht ein vorteilhaftes Lösen bestehender Steckverbindungen (von Bauteil und Adapterelement), bei dem dann das Eingriffselement in der Aufnahme des jeweiligen Aufnahmeelements an der Lauffläche entlanggeführt wird.

Eine derartige Lauffläche kann insbesondere der oben genannten Leitfläche des jeweiligen Aufnahmeelements mindestens bereichsweise gegenüberliegend angeordnet sein: Der besagte Teilbereich und der Abschnitt der Aufnahme, in dem die Leitfläche schräg oder gekrümmt ist, können also mindestens eine Überschneidung aufweisen. Insbesondere können die Leit- und die Lauffläche eines Aufnahmeelements bei einer solchen Ausführungsform vorzugsweise parallel zueinander verlaufen bzw. zumindest abschnittsweise einen konstanten Abstand voneinander aufweisen.

In der Richtung von der Eintrittsöffnung zur Montage-Endposition des jeweiligen Eingriffselements hin betrachtet kann die Lauffläche in dem Teilbereich (bei gekrümmtem Teilbereich im Mittel) beispielsweise einen (kleineren) Winkel β zur vorgesehenen Anschlussrichtung aufweisen, der vorzugsweise wenigstens 25°, wenigstens 35° oder wenigstens 45° beträgt und/oder höchstens 85°, höchstens 75° oder sogar höchstens 65°.

Gemäß vorteilhaften Ausführungsformen sind die beiden Aufnahmeelemente des Adapterelements symmetrisch zueinander angeordnet, wobei eine zugehörige Symmetrieebene sich vorzugsweise entlang der vorgesehenen Anschlussrichtung erstreckt.

Die Aufnahmeelemente des Adapterelements eines erfindungsgemäßen Verbindungssystems sind so zueinander angeordnet, dass ihre jeweiligen Aufnahmen (bzw. Leitflächen) von der jeweiligen Eintrittsöffnung zur jeweiligen Montage-Endposition hin auseinanderlaufen. Dies ermöglicht eine besonders solide Befestigung eines Bauteils in einem angeschlossenen Zustand an dem Adapterelement.

Gemäß vorteilhaften Ausführungsformen weist das Adapterelement mindestens einen hervorstehenden Führungsstift zum Einführen in ein jeweiliges Führungselement am Bauteil auf. Ein derartiger Führungsstift ist vorzugsweise mindestens bereichsweise (insbesondere an seinem der vorgesehenen Anschlussrichtung entgegengesetzten Ende) kegelförmig (zulaufend); dadurch wird ein Einfädeln in ein jeweiliges Führungselement am Bauteil erleichtert. Im Falle des Vorhandenseins mehrerer Führungsstifte können diese alle gleich lang sein, oder das Adapterelement kann mindestens zwei Führungsstifte voneinander verschiedener Länge umfassen.

Der mindestens eine Führungsstift kann bei derartigen Ausführungsformen jeweils dazu eingerichtet sein, in einem montierten (also angeschlossenen) Zustand des Bauteils außen am Bauteil angeordnet zu sein oder mindestens teilweise in dessen Inneres hineinzuragen. Sofern das Bauteil ein Gehäuse umfasst, kann der mindestens eine Führungsstift im angeschlossenen Zustand insbesondere außerhalb oder innerhalb des Gehäuses angeordnet sein. Außenliegende Führungsstifte ermöglichen dabei insbesondere einen vorteilhaften Rückschluss auf den jeweiligen Zustand des Systems.

Insbesondere kann das Adapterelement eines erfindungsgemäßen Verbindungssystems Führungsstifte beider dieser Arten umfassen(dann jeweils wenigstens einen); mindestens ein Führungsstift der erstgenannten (außen am Bauteil anzuordnenden) Art kann in diesem Fall vorzugsweise mindestens doppelt oder sogar mindestens dreimal so lang sein wie mindestens ein Führungsstift der zweitgenannten (mindestens teilweise in ein Inneres des Bauteils hineinragenden) Art. Gemäß vorteilhaften Ausführungsvarianten umfasst das Adapterelement mehrere Führungsstifte der erstgenannten Art, die alle dieselbe Länge aufweisen, und/oder mehrere Führungsstifte der zweitgenannten Art, die alle gleich lang sind. Alternativ oder zusätzlich kann mindestens ein zur Anordnung außen am Bauteil bzw. (gegebenenfalls) außerhalb eines Gehäuses des Bauteils vorgesehener Führungsstift eine Länge aufweisen, die mindestens ein Drittel oder mindestens die Hälfte einer Ausdehnung des Bauteils bzw. Gehäuses in Richtung der vorgesehenen Anschlussrichtung beträgt. Beim Annähern eines anzuschließenden Bauteils an die Adapterplatte ermöglicht dies ein frühzeitiges geeignetes Ausrichten von Bauteil und Adapterelement relativ zueinander und bietet damit insbesondere einen Spielraum für eine gegebenenfalls nötige Korrektur, ohne dass sensible Elemente wie insbesondere Steckerelemente bzw. Steckerkomponenten berührt und damit gefährdet werden.

Das Adapterelement kann eine Grundplatte umfassen, an der das mindestens eine Steckerelement angeordnet sein kann. Die vorgesehene Anschlussrichtung steht dann vorzugsweise senkrecht zu einer Ebene, in der sich die Grundplatte erstreckt. In Ausführungsformen mit Führungsstift(en) wie oben erwähnt kann dann dieser Führungsstift/ mindestens einer dieser Führungsstifte vorzugsweise von der Grundplatte abstehen, insbesondere senkrecht zur Ebene, in der sich die Grundplatte erstreckt.

Gemäß vorteilhaften Ausführungsformen umfasst das Adapterelement mindestens eine Dämpfungseinrichtung, die dazu eingerichtet ist, beim Anschluss eines jeweiligen Bauteils (bzw. beim Herstellen der Steckverbindung von Steckerkomponente des Bauteils und Steckerelement des Adapterelements) komprimiert zu werden. Durch eine derartige Dämpfungseinrichtung kann die Übertragung von Vibrationen zwischen Adapterelement und Bauteil reduziert werden.

Ein erfindungsgemäßer Raumflugkörper weist an seinem Außenbereich mindestens ein Adapterelement eines erfindungsgemäßen Verbindungssystems gemäß einer der in dieser Schrift offenbarten Ausführungsformen auf. Darüber hinaus kann der Raumflugkörper ein zum mindestens einen Adapterelement (jeweils) passendes Bauteil gemäß einer Ausführungsform der vorliegenden Erfindung umfassen:
Das Bauteil eines erfindungsgemäßen Verbindungssystems ist dazu eingerichtet (vorgesehen), an das Adapterelement des Verbindungssystems angeschlossen zu werden. Das Adapterelement kann dabei insbesondere in einem Außenbereich eines (erfindungsgemäßen) Raumflugkörpers angeordnet sein.

Das Bauteil umfasst mindestens eine (elektrische) Steckerkomponente zur Herstellung einer elektrischen Steckverbindung mit einem zum Adapterelement gehörigen (elektrischen) Steckerelement. Die Steckerkomponente kann insbesondere mindestens 10, mindestens 100, mindestens 250 oder sogar mindestens 600 Kontakte zur Verbindung jeweiliger elektrischer Leitungen umfassen. Sie kann jeweils als weiblicher oder männlicher Teil einer Steckverbindung oder als Mischform ausgebildet sein.

Darüber hinaus umfasst das Bauteil zwei Eingriffselemente jeweils zum Eingriff in eine jeweilige Aufnahme am Adapterelement, insbesondere in die Aufnahme eines Aufnahmeelements des Adapterelements. Ein Abstand der Eingriffselemente voneinander ist dabei mittels einer zum Bauteil gehörigen Verstelleinrichtung veränderlich.

Die erfindungsgemäße Veränderlichkeit des genannten Abstandes ermöglicht ein Anschließen des Bauteils an ein geeignetes Adapterelement, bei dem eine hohe Kraft, wie sie zum Herstellen zugehöriger Steckverbindungen erforderlich ist, auf sichere und besonders behutsame Weise aufgebracht werden kann: Wenn die Eingriffselemente jeweils in einer zugehörigen Aufnahme am Adapterelement geführt werden, kann ein jeweiliger Einsteckvorgang über eine Veränderung des Abstandes der Eingriffselemente voneinander kontrolliert gesteuert werden. Beispielsweise in Anwendungsfällen, bei denen weder das Adapterelement noch das Bauteil stabil im Raum gelagert ist (z.B. bei einer Anwendung im Weltraum oder unter Wasser), können die in die Aufnahmen des Adapterelements eingeführten Eingriffselemente auf diese Weise (analog zum Obigen) insbesondere verhindern, dass eine auf das Bauteil ausgeübte Einsteckkraft anstelle eines beabsichtigten Herstellens der Steckverbindung(en) bewirkt, dass das Bauteil das Adapterelement vor sich herschiebt. Analoges gilt jeweils für ein Ablösen des Bauteils vom Adapterelement.

Das Bauteil kann mindestens eine elektronische Schaltung umfassen, insbesondere kann es als ein elektronisches Bauteil ausgebildet sein, beispielsweise mindestens eine Rechnereinheit umfassen.

Gemäß vorteilhaften Ausführungsformen umfasst ein erfindungsgemäßes Bauteil mindestens eine Geradführung, mittels deren mindestens eines der Eingriffselemente zum Ändern des Abstandes vom jeweils anderen Eingriffselement beweglich ist.

Insbesondere kann das mindestens eine Eingriffselement Teil eines Wagens (mit mindestens einem Rad) oder eines Schlittens sein. In Ausführungsformen mit Geradführung kann diese dann eine Führung für den Wagen bzw. Schlitten umfassen, die genau eine eindimensionale Bewegung des Wagens bzw. Schlittens erlaubt (und insbesondere den Wagen/Schlitten am restlichen Bauteil hält).

Die Verstelleinrichtung des Bauteils eines erfindungsgemäßen Verbindungsssystems umfasst eine rotierbare Welle und eine Getriebeeinrichtung zum Umwandeln einer Rotationsbewegung der Welle in eine lineare Bewegung der Eingriffselemente. Auf diese Weise kann der Abstand der Eingriffselemente voneinander vorteilhaft durch Drehung der Welle bewirkt werden. Das Herstellen bzw. Lösen der elektrischen Steckverbindung erfordert damit auch bei hohen aufzubringenden Kräften (die beispielsweise mindestens 500N oder mindestens 750N vorzugsweise höchstens 1200N oder höchstens 1000N betragen können) nur kleine Drehmomente im Bereich einiger (beispielsweise bis zu 50 oder bis zu 25) Newton-Meter.

Insbesondere ermöglicht die vorliegende Erfindung ein Anschluss des Bauteils an das Adapterelement (und damit die Herstellung zugehöriger elektrischer Steckverbindungen) mittels Drehung der Welle. Dies ermöglicht einen vorteilhaften Verzicht auf die Verwendung separater Schrauben, deren Einfädeln in ein Gewinde schwierig sein kann (insbesondere für einen Roboter oder für einen Menschen mit eingeschränkter Feinmotorik wie z.B. bei einem Außeneinsatz im Weltraum).

Die Getriebeeinrichtung kann insbesondere eine Kegelradumlenkung zum Umlenken einer Rotation der Welle in eine Rotation einer Schraubstange umfassen, mit der der Abstand der Eingriffselemente voneinander vorzusweise geändert werden kann. Insbesondere kann eine derartige Schraubstange dazu eingerichtet sein, durch Rotation der Welle zu einer Rotation um ihre Längsachse angetrieben zu werden und dabei eines oder beide Eingriffselemente je nach Rotationsrichtung aufeinander zu oder voneinander weg zu schrauben.

Gemäß vorteilhaften Ausführungsformen eines erfindungsgemäßen Verbindungssystems umfasst das Bauteil mindestens eine Griffeinrichtung, die dazu eingerichtet ist, zum Halten oder Bewegen des Bauteils und/oder zum Bedienen der Verstelleinrichtung lösbar mit einem Werkzeug und/oder (ggf. wahlweise) mit einem Roboterarm verbunden zu werden. Auf diese Weise kann mittels der Griffeinrichtung das Bauteil zum Adapterelement hingeführt bzw. von dieser entfernt werden bzw. der Abstand der Eingriffselemente voneinander verändert und damit die Steckverbindung(en) hergestellt bzw. gelöst werden.

Eine derartige Griffeinrichtung kann beispielsweise ein am Bauteil hervorstehendes, vom Roboterarm bzw. mittels des Werkzeugs zu ergreifendes Griffelement umfassen und/oder eine Aufnahme für zumindest einen Abschnitt des Roboterarms bzw. Werkzeugs, beispielsweise für einen (jeweiligen) Abschnitt, der zum Bewegen (insbesondere Rotieren) eines Elements - wie beispielsweise einer Welle - der Verstelleinrichtung (relativ zur mindestens einen Steckerkomponente) dienen kann. Insbesondere kann die Griffeinrichtung beispielsweise einen Ring umfassen, in dessen Innenbereich die Aufnahme für den genannten Abschnitt ausgebildet ist.

Gemäß vorteilhaften Ausführungsformen umfasst das Bauteil mindestens ein Führungselement zum Führen eines am Adapterelement hervorstehenden Führungsstiftes. Ein von einem derartigen Führungselement ausgebildeter Aufnahmebereich für einen jeweiligen Führungsstift kann sich (beispielsweise entlang einer Kegelfläche, insbesondere trichterförmig) zur dem Adapterelement zuzuwendenden Seite des Bauteils hin weiten; dadurch wird ein Einfädeln eines jeweiligen Führungsstiftes erleichtert.

Das mindestens eine bzw. mindestens eines der Führungselement/e kann außen von einem ggf. umfassten Gehäuse des Bauteils abstehen, so dass dann im montierten Zustand ein zugehöriger Führungsstift außerhalb des Gehäuses angeordnet ist; in diesem Fall kann die Kombination aus Führungselement und Führungsstift einer Grobausrichtung des Bauteils beim Anschluss an das Adapterelement dienen.

Alternativ oder zusätzlich kann das mindestens eine bzw. mindestens eines der Führungselement/e eine Öffnung an einer Seite ausbilden, die zum Anschluss des Bauteils dem Adapterelement zuzuwenden ist; eine derartige Öffnung ist dann dazu eingerichtet, einen Führungsstift des Adapterelements aufzunehmen, der in einem angeschlossenen Zustand des Bauteils mindestens teilweise in dessen Inneres hineinragt. Damit kann eine Stabilisierung des Bauteils in einer vorgegebenen Position relativ zum Adapterelement während des Anschließens an das Adapterelement und danach bewirkt werden. Die Öffnung kann sich vorzugsweise zum Inneren des Bauteils hin trichterförmig verengen. Insbesondere kann ein derartiges Führungselement ein Ringelement umfassen, das die genannte Öffnung umgibt.

Gemäß vorteilhaften Ausbildungsformen ist ein solches Führungselement elastisch gelagert, beispielsweise mittels eines jeweiligen Dämpfungselements. Dadurch können aus Vibrationen resultierende Belastungen reduziert werden. Darüber hinaus erleichtern derartige Dämpfungselemente den Anschluss des Bauteils auch bei großen Temperaturunterschieden zwischen Bauteil und Adapterelement, weil sie einen Spielraum für die jeweilige temperaturbedingte Materialausdehnung schaffen.

Gemäß vorteilhaften Ausführungsformen umfasst ein das Bauteil eines erfindungsgemäßen Verbindungssystems mindestens ein Federungselement, das dazu eingerichtet ist, beim Anschluss des Bauteils an ein jeweiliges Adapterelement (bzw. beim Herstellen der Steckverbindung von Steckerkomponente des Bauteils und Steckerelement des Adapterelements) komprimiert zu werden. Derartige Federelemente bewirken beim Anschluss des Bauteils an ein geeignetes (insbesondere erfindungsgemäßes) Adapterelement, dass die Eingriffselemente gegen eine jeweilige Leitfläche am Adapterelement gedrückt werden, beispielsweise während ihr Abstand mittels der Verstelleinrichtung geändert wird. Dies ermöglicht ein besonders kontrolliertes und behutsames Herstellen und Lösen der Steckverbindungen insbesondere unter Vibrationsbedingungen. In einem an eine Adapterplatte angeschlossenen Zustand eines Bauteils reduzieren solche Federungselemente Schwingungsübergänge zwischen Adapterplatte und Bauteil, wirken also als Dämpfungen. Vorzugsweise ist das mindestens eine Federelemente in einem Randbereich einer dem Adapterelement zugewandten bzw. zuzuwendenden Seite des Bauteils angeordnet.

Ein erfindungsgemäßes Anschließverfahren dient dem Anschließen eines Bauteils eines erfindungsgemäßen Verbindungssystems (gemäß einer der in dieser Schrift offenbarten Ausführungsformen) an ein Adapterelement des Verbindungssystems. Das Anschließverfahren umfasst ein Positionieren des Bauteils so, dass dessen Eingriffselemente jeweils an einer Eintrittsöffnung einer Aufnahme eines jeweiligen der Aufnahmeelemente des Adapterelements angeordnet sind. Das Positionieren kann dabei insbesondere ein Ändern eines Abstandes zwischen Bauteil und Adapterelement umfassen und/oder (bei entsprechenden Ausführungsformen von Adapterelement und Bauteil) ein Einführen von Führungsstiften am Adapterelement in zugehörige Führungselemente des Bauteils.

Weiterhin umfasst ein erfindungsgemäßes Anschließverfahren ein Herstellen einer elektrischen Steckverbindung zwischen dem mindestens einen Steckerelement des Adapterelements und der mindestens einen Steckerkomponente des Bauteils. Dazu werden die Eingriffselemente des Bauteils in den Aufnahmen der Aufnahmeelemente des Adapterelements zu ihrer jeweilige Montage-Endposition hingeführt. Das Hinführen umfasst dabei ein Ändern eines Abstands der Eingriffselemente voneinander durch Betätigen der Verstelleinrichtung des Bauteils.

Das Anschließverfahren kann darüber hinaus ein Greifen des Bauteils (in entsprechenden Ausführungsformen beispielsweise an einer davon umfassten Griffeinrichtung) und/oder des Adapterelements umfassen. Das Positionieren des Bauteils und das Betätigen der Verstelleinrichtung sowie ggf. Greifen des Bauteils kann jeweils mittels eines Roboterarms, insbesondere automatisch vorgenommen werden.

Ein erfindungsgemäßes Ablöseverfahren dient dem Lösen eines Bauteils eines erfindungsgemäßen Verbindungssystems (gemäß einer der in dieser Schrift offenbarten Ausführungsformen) von einem Adapterelement des Verbindungssystems. Das Ablöseverfahren umfasst ein Herausführen der Eingriffselemente des Bauteils aus ihrer jeweiligen Montage-Endposition in einer durch ein jeweiliges Aufnahmeelement ausgebildeten Aufnahme, indem ein Abstand der Eingriffselemente voneinander mittels Betätigens der Verstelleinrichtung geändert wird.

Darüber hinaus kann das Ablöseverfahren ein Greifen des Bauteils (in entsprechenden Ausführungsformen beispielsweise an einer davon umfassten Griffeinrichtung) und/oder ein Entfernen des Bauteils vom Adapterelement umfassen. Das Betätigen der Verstelleinrichtung sowie - in entsprechenden Ausführungsformen - das Greifen bzw. Entfernen kann jeweils mittels eines Roboterarms, insbesondere automatisch vorgenommen werden.

Im Folgenden werden bevorzugte Ausführungsbeispiele der Erfindung anhand von Zeichnungen näher erläutert. Es versteht sich, dass einzelne Elemente und Komponenten auch anders kombiniert werden können als dargestellt. Bezugszeichen für einander entsprechende Elemente sind figurenübergreifend verwendet und werden ggf. nicht für jede Figur neu beschrieben.

Es versteht sich, dass reale Größenverhältnisse von den dargestellten abweichen können.

Es zeigen schematisch:
- Figur 1:: eine exemplarische Ausführungsform eines Adapterelements eines erfindungsgemäßen Verbindungssystems;
- Figur 2a:: eine exemplarische Ausführungsform eines Bauteils eines erfindungsgemäßen Verbindungssystems;
- Figur 2b:: einen Wagen des Bauteils der Figur 2a mit einem Eingriffselement;
- Figur 3:: ein erfindungsgemäßes Verbindungssystem gemäß einem Ausführungsbeispiel in verbundenem Zustand;
- Figur 4:: eine erste Schnittansicht des Verbindungssystems der Figur 3;
- Figur 5:: eine zweite Schnittansicht des Verbindungssystems der Figur 3 und
- Figur 6:: eine dritte Schnittansicht des Verbindungssystems der Figur 3.

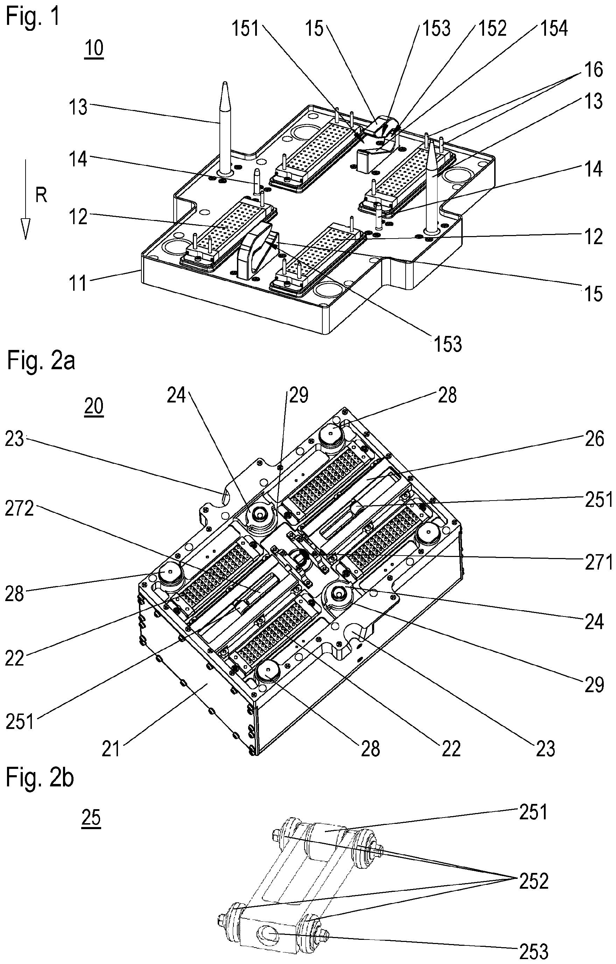

In Figur 1 ist in perspektivischer Ansicht ein Ausführungsbeispiel eines Adapterelements 10 eines erfindungsgemäßen Verbindungssystems dargestellt. Das Adapterelement 10 dient dem Anschließen eines (in der Figur 1 nicht dargestellten) Bauteils, das dazu in der vorgesehenen Anschlussrichtung R relativ zum Adapterelement 10 zu bewegen ist.

Das Adapterelement 10 umfasst vorliegend eine Grundplatte 11 mit vier darauf angeordneten Steckerelementen 12, von denen aus Gründen der besseren Übersichtlichkeit nur zwei bezeichnet sind. Die Steckerelemente 12 sind dazu eingerichtet, zum Herstellen einer elektrischen Steckverbindung mit jeweiligen Steckerkomponenten eines (nicht dargestellten) anzuschließenden Bauteils verbunden zu werden.

Zwei erste von der Grundplatte 11 abstehende Führungsstifte 13 und zwei zweite von der Grundplatte 11 abstehende Führungsstifte 14 stehen jeweils der vorgesehenen Anschlussrichtung R entgegen von der Grundplatte 11 ab und sind dazu eingerichtet, in ein jeweiliges Führungselement am Bauteil eingeführt zu werden. Darüber hinaus weisen die Steckerelemente 12 (im dargestellten Ausführungsbeispiel jeweils drei) Steckstifte 16 zum Fixieren einer jeweiligen elektrischen Steckverbindung mit einer jeweils anzuschließenden Steckerkomponente auf.

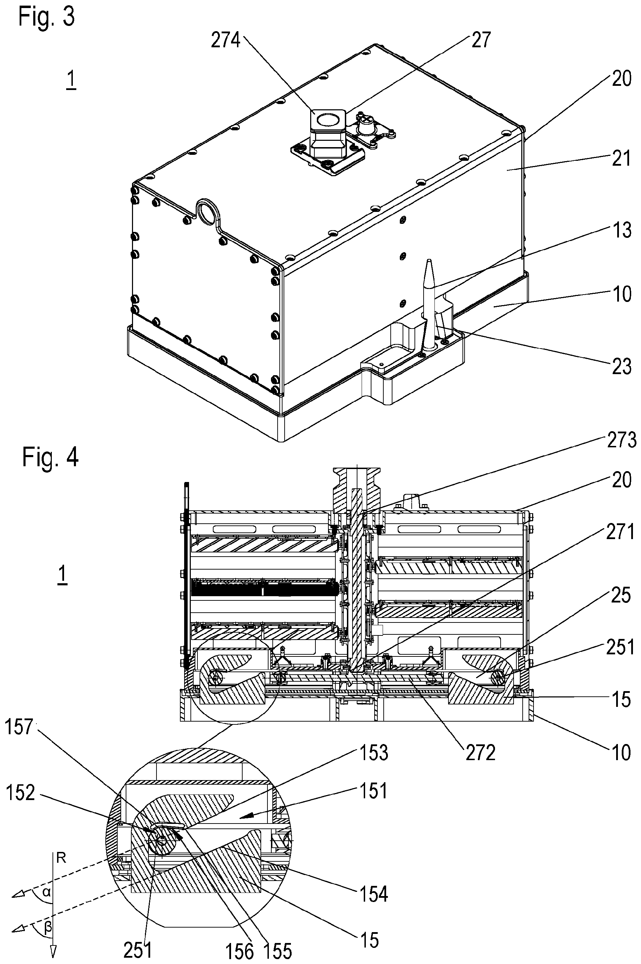

Die ersten Führungsstifte 13 sind dabei dazu eingerichtet, in einem angeschlossenen Zustand außen am Bauteil angeordnet zu sein; dies ist in der Figur 3 zu erkennen, wo die Führungsstifte außerhalb eines zum Bauteil 20 gehörigen Gehäuses 21 angeordnet sind. Beim Anschließen des Bauteils ermöglicht diese Position insbesondere vorteilhaft einen Rückschluss auf den jeweiligen aktuellen Zustand des Systems. Die zweiten Führungsstifte 14 hingegen sind dazu eingerichtet, im montierten (angeschlossenen) Zustand in das Innere eines (in der Figur 1 nicht dargestellten) angeschlossenen Bauteils hineinzuragen.

Die ersten Führungsstifte 13 weisen vorliegend alle (beide) dieselbe Länge auf, und auch die zweiten Führungsstifte 14 sind im gezeigten Ausführungsbeispiel alle (beide) gleich lang; alternativ könnten die ersten Führungsstifte 13 voneinander verschiedene Länge aufweisen und/oder die zweiten Führungsstifte 14 könnten unterschiedlich lang sein.

In der exemplarisch dargestellten Ausführungsform sind die ersten Führungsstifte (jeweils) mehr als doppelt so lang wie die zweiten Führungsstifte 14.

Das in der Figur 1 gezeigte Adapterelement 10 weist weiterhin zwei hakenförmige Aufnahmeelemente 15 auf, die jeweils eine Aufnahme mit einer Eintrittsöffnung 151 und einer Montage-Endposition 152 für ein in der Figur 1 nicht dargestelltes Eingriffselement des anzuschließenden (ebenfalls nicht gezeigten) Bauteils ausbilden.

Der vorgesehenen Anschlussrichtung R entgegen werden die Aufnahmen jeweils durch eine Leitfläche 153 begrenzt, die in einem Abschnitt zwischen der Eintrittsöffnung 151 und der Montage-Endposition 152 schräg zur vorgesehenen Anschlussrichtung R verläuft. Der vorgesehenen Anschlussrichtung R folgend werden die Aufnahmen jeweils durch eine Lauffläche 154 begrenzt. In einem Teilbereich der Aufnahmen verlaufen die Laufflächen 154 dabei schräg zur vorgesehenen Anschlussrichtung R.

Die vorzugsweise starr ausgebildeten Aufnahmeelemente 15 sind bei der dargestellten Ausführungsform einander gegenüberliegend bzw. symmetrisch zueinander angeordnet; eine zugehörige Symmetrieebene verläuft insbesondere entlang der vorgesehenen Anschlussrichtung R (und ist vorliegend durch die Längsachsen der Führungsstifte 14 bestimmt). Von den jeweiligen Eintrittsöffnungen 151 zu den jeweiligen Montage-Endpositionen 152 hin laufen die Aufnahmen der Aufnahmeelemente 15 dabei auseinander und jeweils schräg zur Grundplatte 11 hin.

Wird ein Abstand jeweils in die Aufnahmen eingesetzter Eingriffselemente eines anzuschließenden Bauteils vergrößert, führen die Aufnahmen die Eingriffselemente somit zur jeweiligen Montage-Endposition hin und damit weiter an die Grundplatte 11 heran. Mit den Eingriffselementen werden dann auch jeweilige Steckerkomponenten zur Grundplatte hin bewegt und dabei in ein jeweils zugehöriges Steckerelement 12 des Adapterelements 10 eingesteckt, so dass eine elektrische Steckverbindung hergestellt wird.

In der Figur 2a ist ein exemplarisches Ausführungsbeispiel eines Bauteils 20 eines erfindungsgemäßen Verbindungssystems in perspektivischer Darstellung von einer einem jeweiligen Adapterelement zuzuwendenden Seite gezeigt.

Das Bauteil 20 weist vorliegend ein Gehäuse 21 sowie vier Steckerkomponenten 22 zum Herstellen einer elektrischen Steckverbindung mit einem jeweiligen Steckerelement an einem in der Figur 2a nicht dargestellten Adapterelement auf, beispielsweise mit je einem Steckerelement 12 des in der Figur 1 dargestellten Adapterelements 10.

Zwei erste Führungselemente 23 bilden jeweils einen Aufnahmebereich für einen jeweiligen von der (in der Figur 2a nicht gezeigten) Adapterplatte abstehenden Führungsstift aus, beispielsweise jeweils für einen der Führungsstifte 13 der in der Figur 1 gezeigten Adapterlatte 10. Die Aufnahmebereiche weiten sich jeweils entlang einer Kegelfläche zur dem Adapterelement zuzuwendenden Seite hin. Die Führungselemente 23 stehen dabei außen vom Bauteil ab, so dass im angeschlossenen Zustand hindurchgeführte Führungsstifte außen am Bauteil angeordnet sind, wie dies auch in der Figur 3 zu sehen ist.

Zwei weitere Führungselemente 24 sind ebenfalls zum Hindurchführen an der Adapterplatte angeordneter Führungsstifte (beispielsweise der in Figur 1 gezeigten Führungsstifte 14) vorgesehen, die dann jedoch ins Innere des Bauteils ragen. Die Führungselemente 24 sind dabei jeweils ringförmig ausgebildet; ihre jeweilige innere Öffnung verengt sich trichterförmig zum Inneren des Bauteils hin. Die Ringelemente sind mittels jeweiliger Dämpfungselemente 29 jeweils elastisch gelagert; dadurch können aus Vibrationen resultierende Belastungen reduziert werden. Federungselemente 28 an der dem Adapterelement zuzuwendenden Seite des Bauteils sind dazu eingerichtet ist, beim Anschluss des Bauteils 20 komprimiert zu werden und damit ebenfalls Vibrationen abzufangen.

Darüber hinaus weist das Bauteil 20 zwei Eingriffselemente 251 auf, deren Abstand zueinander mittels einer Verstelleinrichtung veränderlich ist, von der in der Figur 2a nur eine Kegelradumlenkung 271 und eine zugehörige Schraubstange 272 erkennbar sind.

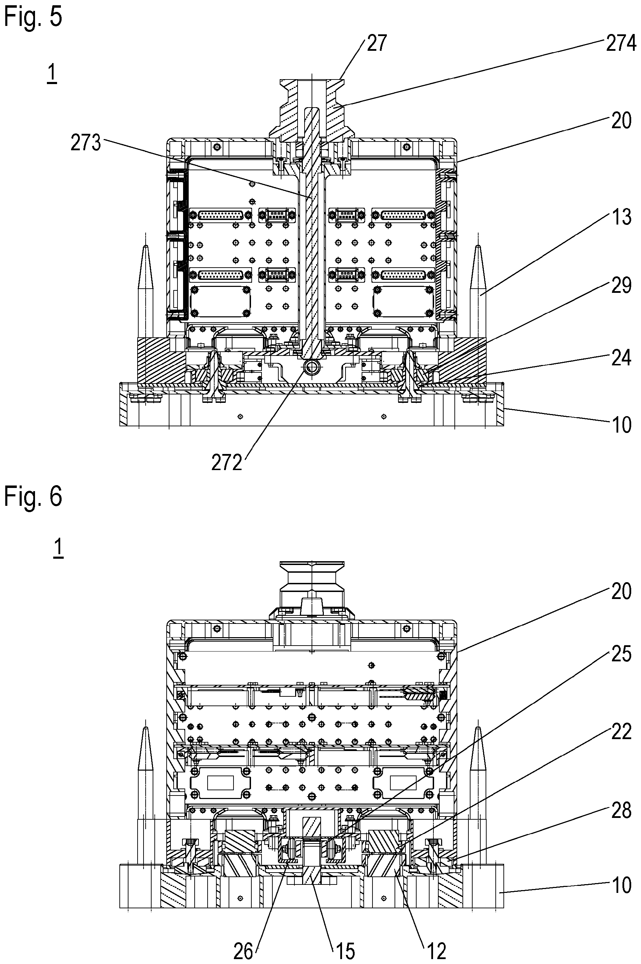

Die Eingriffselemente 251 sind dazu vorgesehen, zum Anschließen des Bauteils 20 an ein Adapterelement in der Aufnahme eines jeweiligen Aufnahmeelements zu einer jeweiligen Montage-Endposition geführt zu werden. Sie sind vorliegend an je einem Wagen 25 angeordnet, der in der Figur 2b separat (und im Vergleich zur Figur 2a vergrößert) dargestellt ist. Jeder Wagen 25 umfasst dabei im dargestellten Ausführungsbeispiel zudem vier Räder 252. Durch eine Öffnung 253, die ein Innengewinde aufweist, ist im in der Figur 2a gezeigten Zustand die Schraubstange 272 der Verstelleinrichtung geführt; eine Drehung der Schraubstange bewirkt dann eine Bewegung jedes Wagens in einer Geradführung 26 (und in Richtung der Längsachse der Schraubstange) und damit eine Änderung des Abstandes der Eingriffselemente 251 der beiden Wagen 25 voneinander. Die Geradführung 26 umfasst dabei zwei parallel zueinander verlaufende Schienen, siehe dazu auch die Schnittdarstellung der Figur 6.

Sind die Eingriffselemente 251 in ein jeweiliges Aufnahmeelement am Adapterelement, insbesondere in die Aufnahmeelemente 15 des in der Figur 1 gezeigten Adapterelements 10 eingesetzt, werden sie durch die Veränderung ihres Abstandes in der Aufnahme des Aufnahmeelements entlanggeführt. Die schräge Leit- bzw. Lauffläche bewirkt dann eine Bewegung des Bauteils in Richtung der vorgesehenen Anschlussrichtung oder ihr entgegen und damit ein Herstellen bzw. Lösen einer elektrischen Steckverbindung der Steckerkomponenten 22 mit jeweiligen Steckerelementen am Adapterelement.

Dabei erfolgt die Änderung des Abstandes und damit der genannte Einsteck- bzw. Ablösevorgang durch eine Drehung der Schraubstange, die ihrerseits vermöge der Kegelradumlenkung 271 durch Rotation einer Welle 273 der Verstelleinrichtung 27 bewirkt wird: Dies ist in den Figuren 3 bis 5 erkennbar, die jeweils (wie auch die Figur 6) ein erfindungsgemäßes Verbindungssystem 1 in einem Zustand zeigen, in dem das Bauteil 20 an das Adapterelement 10 angeschlossen ist.

Die Verstelleinrichtung 27 umfasst dabei vorliegend eine Griffeinrichtung 274, an der das Bauteil 20 gehalten und bewegt werden kann und die dazu insbesondere mit einem Werkzeug und/oder Roboterarm verbunden werden kann. Im dargestellten Ausführungsbeispiel umfasst die Griffeinrichtung 274 exemplarisch ein ringartig geformtes, am Bauteil hervorstehendes Griffelement, das von einem Roboterarm bzw. mittels des Werkzeugs ergriffen werden kann. Das ringartig geformte Griffelement umgibt dabei eine Aufnahme für zumindest einen Abschnitt des Roboterarms bzw. Werkzeugs. Damit erlaubt die Griffeinrichtung 274 einen Zugriff auf die Welle 273 der Verstelleinrichtung 27. Es versteht sich, dass eine Griffeinrichtung als Schnittstelle zu einem Roboterarm zum Bewirken einer Rotation der Welle 273 alternativ auch anders ausgebildet sein kann als die dargestellte Griffeinrichtung 274.

Die Schnittdarstellung der Figur 4 zeigt zudem die Ausbildung der Aufnahmeelemente 15 mit einem jeweiligen in seiner Montage-Endposition befindlichen Eingriffselement 251. Wie insbesondere aus der zugehörigen Detailansicht ersichtlich, weist die Leitfläche 153 einen Abschnitt auf, in dem sie schräg zur vorgesehenen Anschlussrichtung R verläuft, mit der sie nämlich - in einer Richtung von der Eintrittsöffnung zur Montage-Endposition hin betrachtet - einen (kleineren) Winkel α einschließt, der vorliegend in einem besonders vorteilhaften Bereich von 35° bis 75° liegt. Analog weist die Lauffläche 154 einen Teilbereich auf, der - in einer Richtung von der Eintrittsöffnung zur Montage-Endposition hin betrachtet - mit der vorgesehenen Anschlussrichtung R einen (kleineren) Winkel β einschließt, der vorliegend in einem besonders vorteilhaften Bereich von 35° bis 75° liegt. Insbesondere liegen der genannte Abschnitt der Leitfläche 153 und der genannte Teilbereich der Lauffläche 154 im dargestellten Ausführungsbeispiel einander gegenüber und verlaufen die Leitfläche 153 und die Lauffläche 154 dort parallel zueinander.

Zwischen der Eintrittsöffnung 151 und der Montage-Endposition 152 bilden die Leitflächen 153 jeweils eine Kante 155 aus, zudem erstreckt sich die Aufnahme im Bereich der Montage-Endposition 152 jeweils der vorgesehenen Anschlussrichtung R entgegen; die Aufnahmen 153 bilden in diesem Bereich somit eine Sicherungsnische 156 für das in seiner Montage-Endposition angeordnete Eingriffselement 251 aus. Dadurch wird dieses jeweils in seiner Montage-Endposition gesichert, insbesondere wird die Gefahr eines Herauslösens infolge von Vibrationen gemindert. Darüber hinaus weist die Aufnahme im Bereich der Sicherungsnische ein elastisches Element 157 auf, das hier als (dünner) Steg bzw. als Blattfeder ausgebildet ist. Das elastische Element 157 ist dazu eingerichtet, einen Schwingungsübergang zwischen Eingriffselement 251 und Aufnahmeelement 15 zu reduzieren bzw. abzudämpfen.

Offenbart ist ein Adapterelement 10 zum Anschließen eines Bauteils. Das Adapterelement umfasst mindestens ein Steckerelement 12 zum Herstellen einer elektrischen Steckverbindung mit einer zum Bauteil gehörigen Steckerkomponente sowie mindestens zwei Aufnahmeelemente 15, die jeweils eine Aufnahme mit einer Eintrittsöffnung 151 und einer vorgesehenen Montage-Endposition 152 für ein jeweiliges zum Bauteil gehöriges Eingriffselement ausbilden. Entgegen einer vorgesehenen Anschlussrichtung R werden die Aufnahmen jeweils durch eine Leitfläche 153 begrenzt, die zumindest in einem Abschnitt gekrümmt oder schräg zur vorgesehenen Anschlussrichtung R verläuft.

Offenbart ist ferner ein Bauteil 20 zum Anschluss an ein Adapterelement. Das Bauteil umfasst mindestens eine Steckerkomponente 22 zum Herstellen einer elektrischen Steckverbindung mit einem Steckerelement des Adapterelements und zwei Eingriffselemente 251 jeweils zum Eingriff in eine jeweilige Aufnahme des Adapterelements. Ein Abstand der Eingriffselemente 251 voneinander ist mittels einer zum Bauteil gehörigen Verstelleinrichtung 27 veränderlich.

Weiterhin sind ein Raumflugkörper, ein Verbindungssystem, ein Anschließverfahren und ein Ablöseverfahren offenbart.

**Bezugszeichen**

| | | | |
|---|---|---|---|
| 1 | Verbindungssystem | | |
| 10 | Adapterelement | 20 | Bauteil |
| 11 | Grundplatte | 21 | Gehäuse |
| 12 | Steckerelement | 22 | Steckerkomponente |
| 13, 14 | Führungsstift | 23, 24 | Führungselement |
| 15 | Aufnahmeelement | 25 | Wagen |
| 16 | Steckstift | 26 | Geradführung |
| | | 27 | Verstelleinrichtung |
| | | 28 | Federungselement |
| | | 29 | Dämpfungselement |
| 151 | Eintrittsöffnung | 251 | Eingriffselement |
| 152 | Montage-Endposition | 252 | Rad |
| 153 | Leitfläche | 253 | Öffnung |
| 154 | Lauffläche | | |
| 155 | Kante | 271 | Kegelradumlenkung |
| 156 | Sicherungsnische | 272 | Schraubstange |
| 157 | elastisches Element | 273 | Welle |
| | | 274 | Griffeinrichtung |
| R | vorgesehene Anschlussrichtung | | |

## Patentansprüche

1. Verbindungssystem, das ein Adapterelement (10) und ein damit zu verbindendes oder verbundenes Bauteil (20) umfasst,
wobei das Adapterelement
- mindestens ein Steckerelement (12) zum Herstellen einer elektrischen Steckverbindung mit einer zum Bauteil gehörigen Steckerkomponente durch Bewegen der Steckerkomponente relativ zum Steckerelement in eine vorgesehene Anschlussrichtung (R) sowie
- mindestens zwei Aufnahmeelemente (15) für ein jeweiliges zum Bauteil gehöriges Eingriffselement
umfasst,
wobei die Aufnahmeelemente (15) jeweils eine Aufnahme mit einer vorgesehenen Montage-Endposition (152) für das Eingriffselement ausbilden,
wobei die Aufnahmen entgegen der vorgesehenen Anschlussrichtung (R) jeweils durch eine Leitfläche (153) begrenzt werden, die zumindest in einem Abschnitt gekrümmt oder schräg zur vorgesehenen Anschlussrichtung (R) verläuft,
und wobei das Bauteil
- mindestens eine Steckerkomponente (22) zum Herstellen einer elektrischen Steckverbindung mit einem Steckerelement am Adapterelement und
- zwei Eingriffselemente (251) jeweils zum Eingriff in eine jeweilige Aufnahme am Adapterelement
umfasst,
**dadurch gekennzeichnet,**
**dass** ein Abstand der Eingriffselemente (251) voneinander mittels einer zum Bauteil gehörigen Verstelleinrichtung (27) veränderlich ist,
wobei die Verstelleinrichtung (27) eine rotierbare Welle (273) und eine Getriebeeinrichtung zum Umwandeln einer Rotationsbewegung der Welle in eine lineare Bewegung der Eingriffselemente (251) umfasst;
**dass** die Aufnahme der Aufnahmeelemente (15) der vorgesehenen Anschlussrichtung (R) folgend jeweils durch eine Lauffläche (154) begrenzt wird, die zumindest in einem Teilbereich gekrümmt oder schräg zur vorgesehenen Anschlussrichtung (R) verläuft; dass die Aufnahmen der Aufnahmeelemente jeweils eine Eintrittsöffnung (151) aufweisen
und **dass** die Aufnahmen der Aufnahmeelemente (15) von ihrer jeweiligen Eintrittsöffnung (151) zur jeweiligen Montage-Endposition (152) hin auseinanderlaufen.

2. Verbindungssystem gemäß Anspruch 1, wobei bei mindestens einem der Aufnahmeelemente (15) des Adapterelements
- die Leitfläche (153) zwischen der Eintrittsöffnung (151) und der Montage-Endposition (152) eine Kante (155) ausbildet und/oder
- die Aufnahme im Bereich der Montage-Endposition (152) eine Sicherungsnische (156) für ein Eingriffselement umfasst und/oder
- im Bereich der Montage-Endposition (152) ein elastisches Element (157) angeordnet ist, das dazu eingerichtet ist, einen Schwingungsübergang zwischen Eingriffselement und Aufnahmeelement (15) abzudämpfen.

3. Verbindungssystem gemäß einem der Ansprüche 1 oder 2, wobei das Adapterelement mindestens einen hervorstehenden Führungsstift (13, 14) zum Einführen in ein jeweiliges Führungselement am Bauteil umfasst.

4. Verbindungssystem gemäß einem der vorhergehenden Ansprüche, wobei das Bauteil mindestens eine Geradführung (26) umfasst, mittels deren mindestens eines der Eingriffselemente (251) zum Ändern des Abstands vom anderen Eingriffselement (251) beweglich ist.

5. Verbindungssystem gemäß einem der vorhergehenden Ansprüche, wobei das Bauteil mindestens eine Griffeinrichtung (274) umfasst, die dazu eingerichtet ist, zum Halten oder Bewegen des Bauteils und/oder zum Bedienen der Verstelleinrichtung (27) lösbar mit einem Werkzeug und/oder einem Roboterarm verbunden zu werden.

6. Verbindungssystem gemäß einem der vorhergehenden Ansprüche, wobei das Bauteil ein oder mehrere Führungselement/e (23, 24) zum Führen eines hervorstehenden Führungsstiftes des Adapterelements umfasst.

7. Verbindungssystem gemäß Anspruch 6, wobei das Führungselement (24) bzw. mindestens eines der Führungselemente (24) elastisch gelagert ist.

8. Raumflugkörper mit einem an seinem Außenbereich angeordneten Adapterelement (10) eines Verbindungssystems gemäß einem der vorhergehenden Ansprüche.

9. Anschließverfahren zum Anschließen eines Bauteils (20) eines Verbindungssystems gemäß einem der Ansprüche 1 bis 7 an einer Adapterelement (10) des Verbindungssystems, wobei das Anschließverfahren umfasst:
- ein Positionieren des Bauteils (20) so, dass dessen Eingriffselemente (251) jeweils an einer Eintrittsöffnung (151) eines jeweiligen der Aufnahmeelemente (15) des Adapterelements (10) angeordnet sind;
- ein Herstellen einer Steckverbindung zwischen dem mindestens einen Steckerelement (12) des Adapterelements und der mindestens einen Steckerkomponente (22) des Bauteils (20) durch Hinführen der Eingriffselemente (251) in der jeweiligen Aufnahme des jeweiligen Aufnahmeelements (15) zur zugehörigen Montage-Endposition (152), wobei das Hinführen ein Ändern eines Abstands der Eingriffselemente (251) voneinander mittels Betätigens der Verstelleinrichtung (27) umfasst.

10. Ablöseverfahren zum Lösen eines Bauteils (20) eines Verbindungssystems gemäß einem der Ansprüche 1 bis 7 von einem Adapterelement (10) des Verbindungssystems, wobei das Ablöseverfahren ein Herausführen der Eingriffselemente (251) des Bauteils (20) aus ihrer jeweiligen Montage-Endposition (152) in einer durch ein jeweiliges Aufnahmeelement (15) ausgebildeten Aufnahme umfasst,
wobei das Herausführen mittels eines Änderns eines Abstands der Eingriffselemente (251) voneinander mittels Betätigens der Verstelleinrichtung (27) erfolgt.

## Claims

1. Connection system comprising an adapter element (10) and a component (20) to be connected or connected therewith, wherein the adapter element comprises
- at least one plug element (12) for producing an electrical plug connection with a plug component pertaining to the component by moving the plug component relative to the plug element in a designated connection direction (R)
and
- at least two receiving elements (15) for a respective engagement element pertaining to the component,
wherein the receiving elements (15) each form a receptacle with a designated mounting end position (152) for the engagement element,
wherein the receptacles are each delimited by a guide surface (153) contrary to the designated connection direction, which guide surface runs curved or obliquely to the designated connection direction (R) at least in one section,
and wherein the component comprises
- at least one plug component (22) for producing an electrical plug connection with a plug element on the adapter element and
- two engagement elements (251) each for engagement in a respective receptacle on the adapter element,
**characterized in**
- **that** a spacing of the engagement elements (251) from one another is variable by means of an adjusting device (27) pertaining to the component, wherein the adjusting device (27) comprises a rotatable shaft (273) and a transmission device for conversion of a rotational movement of the shaft into a linear movement of the engagement elements (251);
- **that** the receptacle of the receiving elements (15) following the designated connection direction (R) is in each case delimited by a running surface (154) which at least in a partial region runs in a curved manner or obliquely to the designated connection direction (R);
- **that** the receptacles of the receiving elements each have an inlet opening (151)
- and **that** the receptacles of the receiving elements (15) run from their respective inlet opening (151) to the respective mounting end position (152).

2. Connection system according to Claim 1, wherein in at least one of the receiving elements (15) of the adapter element
- the guide surface (153) between the inlet opening (151) and the mounting end position (152) forms an edge (155) and/or
- in the region of the mounting end position (152) the receptacle comprises a securing niche (156) for an engagement element and/or
- an elastic element (157) is disposed in the region of the mounting end position (152), which is adapted to damp a vibration transition between engagement element and receiving element (15).

3. Connection system according to one of Claims 1 or 2, wherein the adapter element comprises at least one protruding guide pin (13, 14) for introducing into a respective guide element on the component.

4. Connection system according to one of the preceding claims, wherein the component comprises at least one linear guide (26) by means of which at least one of the engagement elements (251) is movable to vary the distance from the other engagement element (251).

5. Connection system according to one of the preceding claims, wherein the component comprises at least one handle device (274) which is adapted to be detachably connected to a tool and/or a robot arm for holding or moving the component and/or for operating the adjusting device (27).

6. Connection system according to one of the preceding claims, wherein the component comprises one or more guide element/s (23, 24) for guiding a protruding guide pin of the adapter element.

7. Connection system according to Claim 6, wherein the guide element (24) or at least one of the guide elements (24) is elastically mounted.

8. Spacecraft with an adapter element (10) of a connection system according to one of the preceding claims, arranged on its outer region.

9. Connection method for connection of a component (20) of a connection system according to one of Claims 1 to 7 to an adapter element (10) of the connection system, wherein the connection method comprises:
- positioning the component (20) so that its engagement elements (251) are each disposed at an inlet opening (151) of a respective one of the receiving elements (15) of the adapter element (10) ;
- producing a plug connection between the at least one plug element (12) of the adapter element and the at least one plug component (22) of the component (20) by guiding the engagement elements (251) in the respective receptacle of the respective receiving element (15) to the appurtenant mounting end position (152), wherein the guiding comprises a changing of a spacing of the engagement elements (251) from one another by means of actuating the adjustment device (27).

10. Detachment method for detaching a component (20) of a connection system according to one of Claims 1 to 7 from an adapter element (10) of the connection system, wherein the detachment method comprises a guiding of the engagement elements (251) of the component (20) out from its respective mounting end position (152) in a receptacle formed by a respective receiving element (15), wherein the guiding is accomplished by means of a change of a spacing of the engagement elements (251) from one another by means of actuating the adjusting device (27).

## Revendications

1. Système de connexion, qui comprend un élément adaptateur (10) et un élément constitutif (20) qui doit être connecté ou qui est connecté à l'aide de celui-ci, l'élément adaptateur
comprenant
- un élément connecteur (12), destiné à établir une connexion enfichable électrique avec un composant mâle faisant partie de l'élément constitutif, en déplaçant le composant mâle par rapport à l'élément connecteur dans une direction de raccordement (R) prévue, ainsi
- qu'au moins deux éléments de logement (15) d'un élément d'engagement respectif, faisant partie de l'élément constitutif,
les éléments de logement (15) constituant chacun un logement avec une position extrême (152) de montage pour l'élément d'engagement,
les logements étant délimités chacun à l'encontre de la direction de raccordement (R) prévue par une surface conductrice (153), qui au moins dans une section s'écoule de manière curviligne ou en oblique par rapport à la direction de raccordement (R) prévue,
et l'élément constitutif
comprenant
- au moins un composant mâle (22), destiné à établir une connexion électrique enfichable avec un élément connecteur sur l'élément adaptateur et
- deux éléments d'engagement (251), destinés à s'engager chacun dans un logement respectif sur l'élément adaptateur,
**caractérisé**
- **en ce qu'**un écart mutuel entre les éléments d'engagement (251) est variable au moyen d'un dispositif d'ajustage (27) faisant partie de l'élément constitutif, le dispositif d'ajustage (27) comprenant un arbre (273) rotatif et un dispositif de transmission, destiné à convertir un déplacement en rotation de l'arbre en un déplacement linéaire des éléments d'engagement (251) ;
- **en ce qu'**en suivant la direction de raccordement (R) prévue, le logement des éléments de logement (15) est chaque dois délimité par une surface de roulement (154), qui au moins dans une zone partielle s'écoule de manière curviligne ou en oblique par rapport à la direction de raccordement (R) prévue ;
- **en ce que** les logements des éléments de logement comportent chacun un orifice d'entrée (151)
- et **en ce que** les logements des éléments de logement (15) s'éloignent l'un de l'autre de l'orifice d'entrée (151) vers la position extrême (152) de montage respective.

2. Système de connexion selon la revendication 1, sur au moins l'un des éléments de logement (15) de l'élément adaptateur
- la surface conductrice (153) créant entre l'orifice d'entrée (151) et la position extrême (152) de montage une arête (155) et/ou
- le logement comprenant dans la position extrême (152) de montage une niche de blocage (156) pour un élément d'engagement et/ou
- dans la zone de la position extrême (152) de montage étant placé un élément (157) élastique, qui est aménagé pour amortir une transition vibratoire entre l'élément d'engagement et l'élément de logement (15).

3. Système de connexion selon l'une quelconque des revendications 1 ou 2, l'élément adaptateur comprenant au moins une tige de guidage (13, 14) saillante, destinée à être introduite dans un élément de guidage respectif sur l'élément constitutif.

4. Système de connexion selon l'une quelconque des revendications précédentes, l'élément constitutif comprenant au moins un guidage rectiligne (26), au moyen duquel au moins l'un des éléments d'engagement (251) est déplaçable, pour faire varier l'écart par rapport à l'autre élément d'engagement (251).

5. Système de connexion selon l'une quelconque des revendications précédentes, l'élément constitutif comprenant au moins un dispositif de préhension (274) qui est aménagé pour être connecté de manière amovible avec un outil et/ou avec un bras de robot, pour maintenir ou pour déplacer l'élément constitutif et/ou pour commander le dispositif d'ajustage (27).

6. Système de connexion selon l'une quelconque des revendications précédentes, l'élément constitutif comprenant un ou plusieurs élément (s) de guidage (23, 24), destiné(s) à guider une tige de guidage saillante de l'élément adaptateur.

7. Système de connexion selon la revendication 6, l'élément de guidage (24) ou au moins l'un des éléments de guidage (24) étant logé de manière élastique.

8. Engin spatial, pourvu d'un élément adaptateur (10) d'un système d'assemblage selon l'une quelconque des revendications précédentes, qui est placé sur sa zone extérieure.

9. Procédé de raccordement, destiné à raccorder un élément constitutif (20) d'un système de connexion selon l'une quelconque des revendications 1 à 7 sur un élément adaptateur (10) du système de connexion, le procédé de raccordement comprenant les étapes consistant à :
- positionner l'élément constitutif (20) de telle sorte que ses éléments d'engagement (251) soient placés chacun sur un orifice d'entrée (151) de l'un respectif des éléments de logement (15) de l'élément adaptateur (10) ;
- établir une connexion enfichable entre l'au moins un élément connecteur (12) de l'élément adaptateur et l'au moins un composant mâle (22) de l'élément constitutif (20), en amenant les éléments d'engagement (251) dans le logement respectif de l'élément de logement (15) respectif vers la position extrême (152) de montage associée, l'amenage comprenant une variation d'un écart mutuel entre les éléments d'engagement (251) au moyen d'un actionnement du dispositif d'ajustage (27) .

10. Procédé des désolidarisation, destiné à désolidariser un élément constitutif (20) d'un système de connexion selon l'une quelconque des revendications 1 à 7 d'un élément adaptateur (10) du système de connexion, le procédé de désolidarisation comprenant l'étape consistant à faire sortir l'élément d'engagement (251) de l'élément constitutif (20) de sa position extrême (152) de montage dans un logement constitué par un élément de logement (15) respectif, la sortie s'effectuant par une variation d'un écart mutuel entre les éléments d'engagement (251) au moyen d'un actionnement du dispositif d'ajustage (27) .
